# EUROPÄISCHE PATENTSCHRIFT

(11) **EP 0 904 602 B1**
(45) Veröffentlichungstag und Bekanntmachung des Hinweises auf die Patenterteilung: **30.01.2002**
(21) Anmeldenummer: 97925908.2
(22) Anmeldetag: 10.06.1997
(51) Int. Cl.: H01L 23/498, H01L 23/24, G06K 19/077, H01L 21/48

(54) **VERFAHREN ZUR HERSTELLUNG EINES TRÄGERELEMENTS FÜR HALBLEITERCHIPS**
METHOD OF MANUFACTURING A CARRIER ELEMENT FOR SEMICONDUCTOR CHIPS
PROCEDE DE FABRICATION D'UN ELEMENT DE SUPPORT POUR PUCES DE SEMI-CONDUCTEUR

(30) Priorität: 14.06.1996 DE 19623826; 16.12.1996 DE 29621837 U
(43) Veröffentlichungstag der Anmeldung: 31.03.1999
(73) Patentinhaber: Infineon Technologies AG, 81669 München (DE)
(72) Erfinder: HUBER, Michael, D-93152 Nittendorf (DE); STAMPKA, Peter, D-92421 Schwandorf-Klardorf (DE); HOUDEAU, Detlef, D-84085 Langquaid (DE); FISCHER, Jürgen, D-93180 Deuerling (DE); HEITZER, Josef, D-93090 Bach (DE); GRAF, Helmut, D-93051 Regensburg (DE)
(74) Vertreter: Epping Hermann & Fischer
(86) Internationale Anmeldenummer: DE9701170
(87) Internationale Veröffentlichungsnummer: WO9748133

(56) Entgegenhaltungen:
- WO-A-91/01533
- US-A- 5 147 982
- PATENT ABSTRACTS OF JAPAN vol. 011, no. 035 (P-542), 3.Februar 1987 & JP 61 204788 A (DAINIPPON PRINTING CO LTD), 10.September 1986,

## Beschreibung

Bei heutigen Chipkarten werden die Halbleiterchips mittels eines zumeist mit einem nicht-leitenden, flexiblen Substrat gebildeten Trägerelements in die üblicherweise aus Kunststoff bestehende Karte eingebracht. Auf dem Trägerelement ist nicht nur der Halbleiterchip sondern es sind auch die Kontaktflächen, mit denen der Halbleiterchip von einem Lesegerät kontaktiert werden kann, angeordnet. Hierzu wird üblicherweise eine oberflächenveredelte Kupferfolie auf das nicht-leitende Substrat laminiert und beispielsweise durch Ätzen strukturiert. In das nicht-leitende Substrat werden vor dem Laminieren Löcher gestanzt, durch die hindurch der Chip beispielsweise mittels Drähte in Wire-Bond-Technik mit den Kontaktflächen elektrisch leitend verbunden werden kann. Der Halbleiterchip und die Drähte werden dann durch eine schützende Vergußmasse abgedeckt.

Die Chipkarten müssen bestimmte, durch die Anwender vorgegebene Biegebelastungen bestehen können. Die hierbei auftretenden Biegekräfte müssen jedoch vom Chip ferngehalten werden, da dieser wesentlich spröder als das Kartenmaterial ist. Dies trifft insbesondere für Chips zu, die größer als etwa 10 mm² sind. Aus der EP 0 484 353 B1 ist es bekannt, hierzu auf dem flexiblen Substrat einen Versteifungsrahmen vorzusehen, der eine wesentlich höhere Biegesteifigkeit aufweist als das flexible Trägersubstrat.

Die Figur 4 zeigt eine Ausführungsform gemäß der EP 0 484 353 B1. Das nicht-leitende, flexible Trägersubstrat 1 ist mit Ausnehmungen 2 versehen. Eine metallische Folie 3 ist auf das Substrat 1 mittels eines Klebers 4 laminiert. Die metallische Folie 3 ist in durch Rillen 5 voneinander elektrisch isolierte Kontaktflächen strukturiert. Ein Halbleiterchip 6 ist auf das Substrat 1 geklebt und mittels Drähte 7 mit den Kontaktflächen 3 elektrisch verbunden. Zur Versteifung des flexiblen Substrates 1 ist ein Versteifungsring 8 auf das Substrat 1 geklebt. Das Innere des Versteifungsringes 8 ist mit einer Vergußmasse 9 gefüllt, um den Chip 6 und die Drähte 7 zu schützen.

Das Aufbringen des Versteifungsrings ist problematisch, da relativ hohe Lagetoleranzen vorgegeben sind und außerdem spezielle, aufwendige Werkzeuge hierfür notwendig sind. Insgesamt ergibt sich eine sehr schwierige und aufwendige Prozeßführung. Außerdem wird durch den bekannten Versteifungsring die zur Klebung des Trägerelementes in die Karte nötige Fläche eingeschränkt.

Die US 5,147,982 zeigt ein Trägerelement, bei dem auf ein gestanztes, Kontaktflächen bildendes Metallgitter eine Kunststoffolie laminiert wird, die einen einstückig angeformten Verstärkungs- und Schutzrahmen aufweist.

Die Aufgabe der Erfindung ist es, ein einfaches Verfahren zur Herstellung eines Trägerelement anzugeben.

Die Aufgabe wird durch ein Verfahren zur Herstellung des Trägerelementes gemäß dem Anspruch 1 gelöst. Vorteilhafte Weiterbildungen sind in den Unteransprüchen angegeben.

Das erfindungsgemäße Verfahren hat den Vorteil, daß dieselben oder ähnliche Verfahrensschritte durchgeführt werden wie bei der Herstellung des Trägersubstrates oder des bekannten Trägerelementes. Dies sind Stanz- bzw. Laminierverfahrensschritte. Da die Versteifungsfolie außerdem dieselbe Außenabmessung hat wie das Trägerelement, können zum Laminieren dieselben Maschinen benutzt werden wie zum Laminieren der die Kontaktflächen bildenden Kupferfolie.

Die Trägerelemente werden normalerweise in einem sehr langen Band gefertigt, wobei mehrere Trägerelemente sogar nebeneinander liegen können. Das Band weist an seinen Rändern Perforationen auf, mittels derer es in der Fertigungsmaschine weiterbefördert werden kann. Wenn auch die Versteifungsfolie diese Löcher aufweist, kann sie in gleicher Weise wie das flexible Trägersubstrat oder die Kontaktflächenfolie befördert und verarbeitet werden,

Durch das Tiefziehen der Kavität entstehen relativ hohe Spannungen, die durch mechanische Belastung beim Auf-, Ab- und Umwickeln der Spule, auf die das Band gewickelt ist, zumindest teilweise freigesetzt werden und dadurch zur Materialbeschädigung im oberen, freistehenden Bereich des Rahmens führen können. In Weiterbildung der Erfindung sind in dem Band nahe den Bereichen der späteren durch Stanzen entstehenden Trägerelemente Entlastungsdurchbrüche, die als Schlitze ausgeführt sein können, vorgesehen. Zur Vermeidung von Kerbwirkungen, die zu Mikrorissen am Rand der Entlastungsdurchbrüche führen können, sind die Kantenübergänge in vorteilhafter Weise abgerundet. Die Entlastungsdurchbrüche sind am Trägerelement nach dem Ausstanzen aus dem Band nicht mehr sichtbar, so daß die Optik der Kontaktflächen dadurch nicht beeinträchtigt wird. Durch Tiefziehen ohne Ecken im Rahmen kann die Elastizität des gesamten Bandes zusätzlich weiter erhöht werden.

Da der durch Tiefziehen und Stanzen entstandene Rahmen entlang des Randes der Ausnehmung in der Versteifungsfolie nur dieselbe Dicke hat wie die Kupferfolie selbst, bleibt imBereich außerhalb dieses Rahmens genügend Platz für einen Kleber, um das Trägerelement in einer Karte befestigen zu können. Die Dicke der Versteifungsfolie kann abhängig von der gewünschten Gesamtbiegesteifigkeit sowie den Materialeigenschaften der verwendeten Folie gewählt werden.

Besonders vorteilhaft ist es, wenn nicht der gesamte Boden der Wanne ausgestanzt wird, sondern ein Steg am Rand des Rahmens verbleibt, der die Biegesteifigkeit zusätzlich erhöht.

Die Erfindung wird nachfolgend anhand eines Ausführungsbeispieles mit Hilfe von Figuren näher erläutert. Dabei zeigen
- Figuren 1a-1d: die Verfahrensschritte zur Herstellung der erfindungsgemäßen Versteifungsfolie sowie eine Draufsicht der fertigen Folie,
- Figuren 2a-2c: das flexible Trägersubstrat, die Versteifungsfolie sowie die Verbindung dieser beiden Teile,
- Figur 3: einen Querschnitt durch ein erfindungsgemäßes Trägerelement,
- Figur 4: ein Trägerelement gemäß dem Stand der Technik und
- Figur 5: eine Versteifungsfolie mit Entlastungsdurchbrüchen.

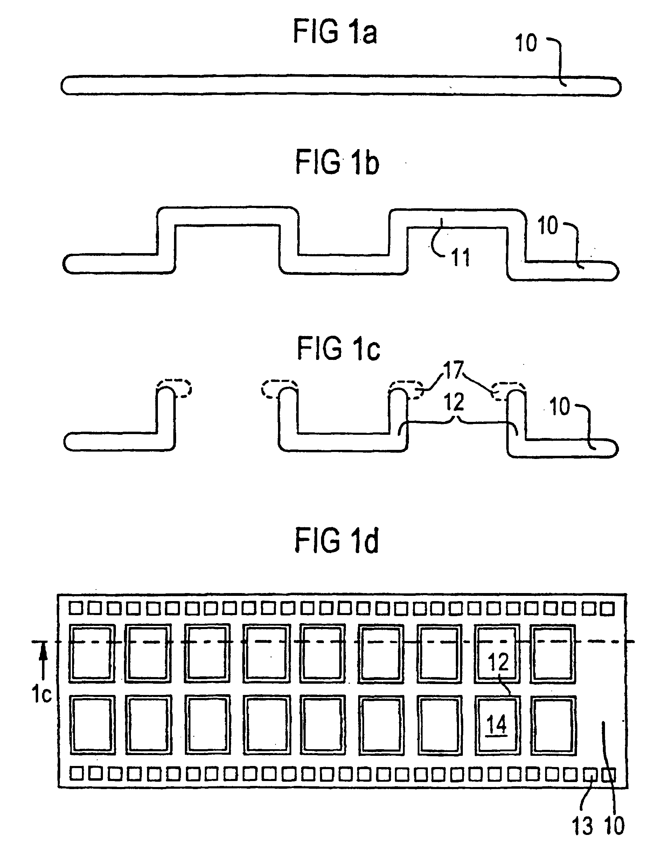

In der Figur 1a ist der Querschnitt durch eine auf die entsprechende Dicke gewalzte metallische Versteifungsfolie dargestellt. In der Figur 1b sind die durch einen Tiefziehvorgang entstandenen Wannen 11 gezeigt. In einem Stanzvorgang werden die Böden der Wannen 11 entfernt, so daß lediglich die Wände der Wannen 11 als Rahmen 12, die einstückig mit der Versteifungsfolie 10 verbunden sind und entlang des Randes der durch die vormaligen Wannen 11 definierten Ausnehmung in der Folie verlaufen, stehenbleiben. In vorteilhafter Weise werden nicht die gesamten Böden der Wannen 11 ausgestanzt, so daß ein -strichliert dargestellter- Steg 17 verbleibt, der eine zusätzliche Biegesteifigkeitserhöhung bringt.

Die Figur 1d zeigt eine Draufsicht auf eine erfindungsgemäße Versteifungsfolie 10, die als langes Band ausgebildet ist. Entlang der beiden Ränder des Bandes sind Perforierungen 13 angebracht, die einen Weitertransport des Bandes mittels Zahnrädern erlauben. Die Folie 10 weist Ausnehmungen 14 auf, entlang deren Ränder die Rahmen 12 verlaufen. Strichliert ist der Schnitt dargestellt, der die Darstellung der Figur 1c bildet.

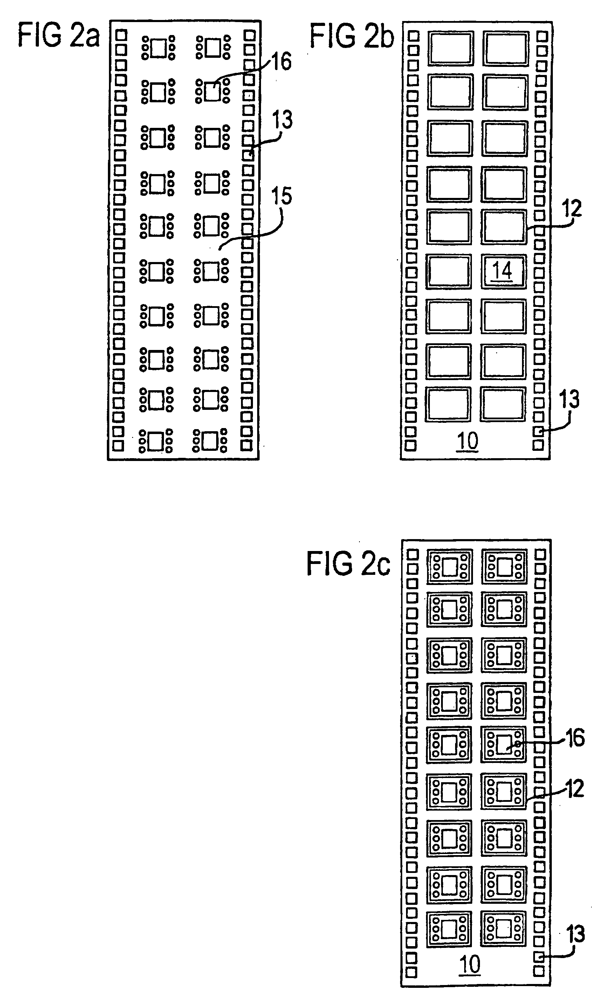

In Figur 2b ist diese erfindungsgemäße Versteifungsfolie nochmals gezeigt. Die Figur 2a zeigt das flexible Trägersubstrat 15, das aus einem Kunststoff gebildet sein kann, wobei heutzutage üblicherweise glasfaserverstärktes Epoxidharz verwendet wird. Auch das Trägersubstrat 15 ist als langes Band ausgebildet und weist an seinen Rändern Perforierungen 13 zum Weitertransport und exakten Positionieren bei Weiterverarbeitungen auf. Das Trägersubstrat 15 weist Stanzungen 16 auf, in die ein nicht dargestellter Halbleiterchip eingesetzt und durch die hindurch dieser Halbleiterchip mit nicht zu erkennenden Kontaktflächen auf der Rückseite des Trägersubstrates 15 elektrisch verbunden werden kann. In der Figur2c ist schließlich die mit dem Trägersubstrat 15 verbundene Versteifungsfolie 10 dargestellt. Die Stanzungen 16 des Trägersubstrates 15 befinden sich innerhalb des einstückig mit der Versteifungsfolie 10 verbundenen Rahmens 12, so daß ein nicht dargestellter Halbleiterchip problemlos in die zentrale Ausnehmung eingesetzt werden kann und durch die peripheren Ausnehmungen im Trägersubstrat 15 mit den auf der Rückseite des Trägersubstrates vorgesehenen, nicht zu sehenden, Kontaktflächen verbunden werden kann.

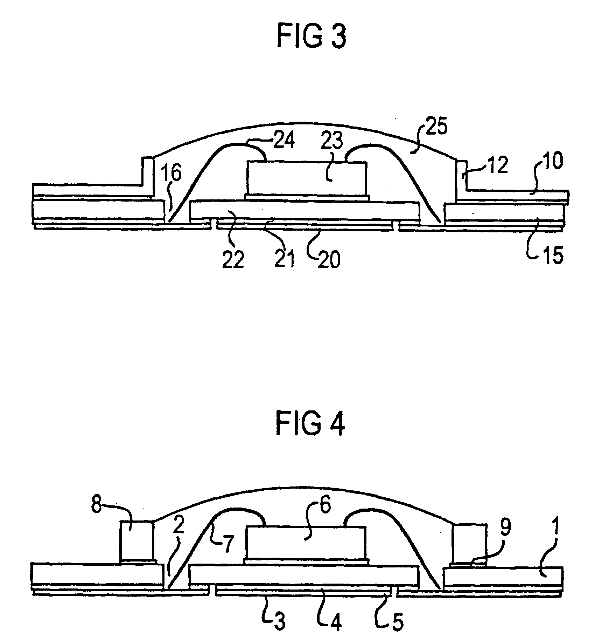

Figur 3 zeigt einen Querschnitt durch ein aus dem Band ausgestanztes Trägerelement. Das nicht-leitende, flexible Trägersubstrat 15 weist in diesem Fall nur periphere durch Stanzung entstandene Ausnehmungen 16 auf. Auf seiner Rückseite ist eine metallische Folie 20, die durch Rillen 22 in Kontaktflächen strukturiert ist mittels eines Klebers 21 laminiert. Auf das Trägersubstrat 15 ist ein Halbleiterchip 23 angeordnet, der mittels Bonddrähte 24 durch die Ausnehmungen 16 des Trägersubstrates 15 mit den Kontaktflächen 20 verbunden ist. Auf der dem Halbleiterchip 23 tragenden Vorderseite des Trägersubstrates 15 ist die erfindungsgemäße Versteifungsfolie 10 mittels eines Klebers auflaminiert. Der Bereich innerhalb des mit der Versteifungsfolie 10 einstückig verbundenen Rahmens 12 ist mit einer Vergußmasse 25 zum Schutz des Halbleiterchips 23 und der Bonddrähte 24 aufgefüllt.

Wie im Vergleich mit der Figur 4 zu sehen ist, verbleibt beim erfindungsgemäßen Trägerelement eine größere Fläche im Bereich des Randes des Trägerelementes, um dieses besser in eine Plastikkarte einkleben zu können.

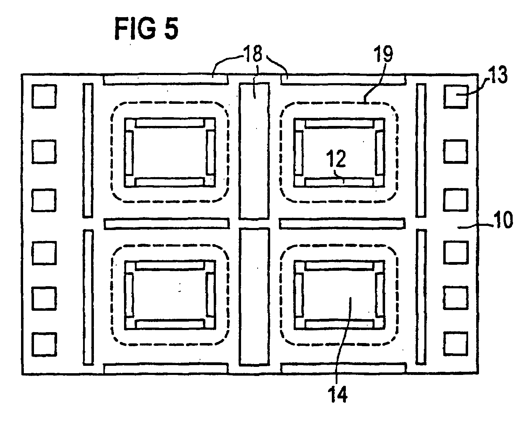

Die Figur 5 zeigt erfindungsgemäße Entlastungsdurchbrüche 18 in der Versteifungsfolie, die außerhalb der strichliert angedeuteten Bereiche 19 späterer durch Stanzen entstehendener Trägerelemente liegen.

Die Figuren 3 und 4 zeigen ein nicht-leitendes Trägersubstrat 15 bzw. 1, das eine die Kontaktflächen bildende Metallkaschierung 20 bzw. 3 aufweist. Prinzipiell ist es jedoch ebenso möglich, ein leitendes, beispielsweise metallisches, Trägersubstrat zu verwenden.

Außerdem ist es ebenso denkbar, für das Material der Versteifungsfolie 10 Kunststoff zu wählen. Hierbei wären auch andere Herstellverfahren als Tiefziehen und Stanzen denkbar.

## Patentansprüche

1. Verfahren zur Herstellung eines Trägerelements für einen Halbleiterchip (23), insbesondere zum Einbau in eine Chipkarte, mit den Schritten:
- in eine Versteifungsfolie (10) wird durch Tiefziehen eine Wanne (11) geformt,
- der Boden der Wanne wird ausgestanzt, so daß eine den Chip (23) und seine Anschlußleitungen ((24) aufnehmende Ausnehmung entsteht, die somit eine einstückig aus der Versteifungsfolie (10) gebildete Umrahmung (12) aufweist
- die Versteifungsfolie (10) wird auf die den Chip (23) tragende Seite eines flexiblen Substrats (15) laminiert.

2. Verfahren nach Anspruch 1,
**dadurch gekennzeichnet,**
**daß** das Substrat (15) eine nicht-leitende Folie ist, auf die auf der dem Chip (23) gegenüberliegenden Seite eine leitende, in Kontaktflächen strukturierte Folie (20) laminiert wird.

3. Verfahren nach Anspruch 1,
**dadurch gekennzeichnet,**
**daß** das Substrat (15) eine Metallfolie ist.

4. Verfahren nach einem der Ansprüche 1 bis 3,
**dadurch gekennzeichnet,**
**daß** die Versteifungsfolie (10) aus Metall ist.

5. Verfahren nach einem der Ansprüche 1 bis 3,
**dadurch gekennzeichnet,**
**daß** die Versteifungsfolie (10) aus Kunststoff ist.

6. Verfahren nach einem der vorhergehenden Ansprüche,
**dadurch gekennzeichnet,**
**daß** das Substrat (15) eine nicht-leitende Folie ist, auf die auf der der Versteifungsfolie (10) gegenüberliegenden Seite eine leitende, in Kontaktflächen strukturierte Folie (20) laminiert wird.

7. Verfahren nach einem der vorhergehenden Anprüche,
**dadurch gekennzeichnet,**
**daß** nicht der gesamte Boden der Wanne ausgestanzt wird, so daß der nicht mit der Folie (10) verbundene Rand des Rahmens (12) mit einem etwa senkrecht zum Rahmen (12) verlaufenden, einstückig mit dem Rahmen (12) ausgebildeten Steg (17) versehen ist.

8. Verfahren nach einem der vorhergehenden Anprüche,
**dadurch gekennzeichnet,**
**daß** in der Versteifungsfolie (10) außerhalb des späteren Trägerelementbereiches (19) Entlastungsdurchbrüche (18) angebracht werden.

## Claims

1. Method for producing a carrier element for a semiconductor chip (22), in particular to be built into a smart card, having the steps:
- a trough (11) is formed in a stiffening sheet (10) by deep-drawing,
- the bottom of the trough is stamped so as to produce a recess that receives the chip (23) and its connection leads (24) and thereby has a frame (12) formed integrally from the stiffening foil (10),
- the stiffening foil (10) is laminated onto that side of a flexible substrate (15) which carries the chip (23).

2. Method according to Claim 1, **characterized in that** the substrate (15) is a non-conducting sheet, onto which a conductive sheet (20), structured into contact faces, is laminated on the opposite side from the chip (23).

3. Method according to Claim 1, **characterized in that** the substrate (15) is a foil.

4. Method according to one of Claims 1 to 3, **characterized in that** the stiffening sheet (10) is made of metal.

5. Method according to one of Claims 1 to 3, **characterized in that** the stiffening sheet (10) is made of plastic.

6. Method according to one of the preceding claims, **characterized in that** the substrate (15) is a non-conducting sheet, onto which a conductive sheet (20), structured into side contact faces, is laminated on the opposite side from the stiffening sheet (10).

7. Method according to one of the preceding claims, **characterized in that** not all of the bottom of the trough is stamped, so that the edge of the frame (12) that is not connected to the sheet (10) is provided with a web (17) that extends substantially perpendicular to the frame (12) and is formed integrally with the frame (12).

8. Method according to one of the preceding claims, **characterized in that** stress-relief holes (18) are made in the stiffening sheet (10) outside the subsequent carrier-element region (19).

## Revendications

1. Procédé de fabrication d'un élément de support pour une puce (23) à semi-conducteur, destiné notamment à être incorporé dans une carte à puce comprenant les stades :
- on forme dans une feuille (10) de rigidification, une cuvette (11) par emboutissage profond,
- on découpe le fond de la cuvette, de manière à former une cavité qui reçoit la puce (23) et ses lignes (24) de raccordement, et qui comporte ainsi une bordure (12) formée d'une pièce dans la feuille (10) de rigidification,
- on applique la feuille (10) de rigidification sur la face d'un substrat (15) souple, qui porte la puce (23).

2. Procédé suivant la revendication 1, **caractérisé en ce que** le substrat (15) est une feuille conductrice, sur laquelle est appliquée, du côté opposé à la puce (23), une feuille (20) conductrice structurée en surfaces de contact.

3. Procédé suivant la revendication 1, **caractérisé en ce que** le substrat (15) est une feuille métallique.

4. Procédé suivant l'une des revendications 1 à 3, **caractérisé en ce que** la feuille (10) de rigidification est en métal.

5. Procédé suivant l'une des revendications 1 à 3, **caractérisé en ce que** la feuille (10) de rigidification est en matière plastique.

6. Procédé suivant l'une des revendications précédentes, **caractérisé en ce que** le substrat (15) est une feuille non conductrice sur le côté opposé à la feuille (10) de rigidification de laquelle, est appliquée une feuille (20) conductrice structurée en surfaces de contact.

7. Procédé suivant l'une des revendications précédentes, **caractérisé en ce que** tout le fond de la cuvette n'est pas découpé, de sorte que le bord du cadre (12) qui n'est pas relié à la feuille (10), est muni d'un rebord (17) s'étendant à peu près perpendiculairement au cadre (12) et d'une pièce avec le cadre (12).

8. Procédé suivant l'une des revendications précédentes, **caractérisé en ce qu'**il est ménagé dans la feuille (10) de rigidification, à l'extérieur de la partie servant ultérieurement d'élément de support, des traversées (18) de soulagement.
